(19) Europäisches Patentamt
European Patent Office
Office européen des brevets

(11) EP 2 372 454 A1

(12) **EUROPÄISCHE PATENTANMELDUNG**

(43) Veröffentlichungstag:
**05.10.2011 Patentblatt 2011/40**

(51) Int Cl.:
*G03F 7/00* (2006.01) *G03H 1/02* (2006.01)
*G03F 7/031* (2006.01)

(21) Anmeldenummer: **10158100.7**

(22) Anmeldetag: **29.03.2010**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**AL BA ME RS**

(71) Anmelder: **Bayer MaterialScience AG**
**51368 Leverkusen (DE)**

(72) Erfinder:
- **Weiser, Dr. Marc-Stephan**
  **51379 Leverkusen (DE)**
- **Rölle, Dr. Thomas**
  **51381 Leverkusen (DE)**
- **Bruder, Dr. Friedrich-Karl**
  **47802 Krefeld (DE)**
- **Fäcke, Dr. Thomas**
  **51375 Leverkusen (DE)**
- **Hönel, Dennis**
  **53909 Zülpich-Wichterich (DE)**

(54) **Photopolymer-Formulierung zur Herstellung sichtbarer Hologramme**

(57) Die Erfindung betrifft eine Photopolymer-Formulierung umfassend chemisch vernetzte Matrixpolymere, Schreibmomomere und ein Photoinitiatorsystem, wobei das Photoinitiatorsystem ein HABI, einen auf das HABI abgestimmten Farbstoff mit einem Absorptionsmaximum im Bereich von 400-800 nm und einen Wasserstoff-Donor enthält. Weitere Gegenstände der Erfindung sind die Verwendung der Photopolymer-Formulierung zur Herstellung von optischen Elementen, insbesondere zur Herstellung von holographischen Medien sowie ein Verfahren zur Herstellung belichteter holographischer Medien.

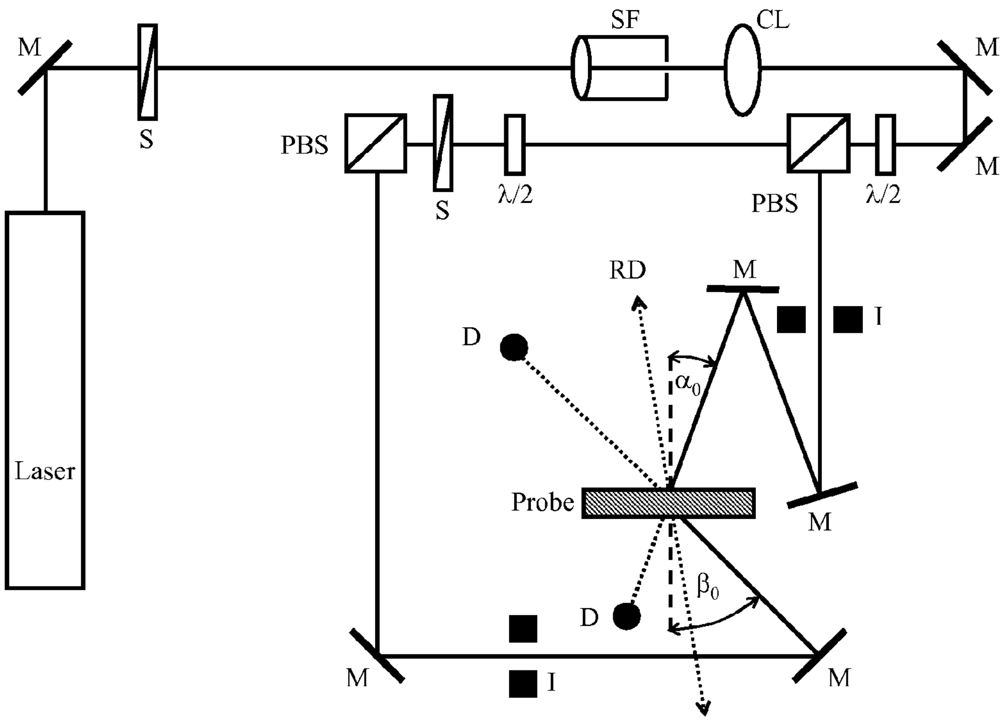


Fig. 1

EP 2 372 454 A1

**Beschreibung**

Die Erfindung betrifft eine Photopolymer-Formulierung umfassend chemisch vernetzte Matrixpolymere, Schreibmomomere und ein Photoinitiatorsystem, die Verwendung der Photopolymer-Formulierung zur Herstellung von holographischen Medien sowie ein Verfahren zur Herstellung belichteter holographischer Medien.

In der WO 2008/125229 A1 sind Photopolymer-Formulierungen der eingangs genannten Art beschrieben. Diese umfassen chemisch vernetzte Polyurethan-basierte Matrixpolymere, Schreibmomomere auf Acrylbasis sowie ein Photoinitiatorsystem.

In Medien aus der bekannten Photopolymer-Formulierung können mit Hilfe elektromagnetischer Strahlung Hologramme einbelichtet werden. Allerdings werden in der Anmeldung primär Formulierungen für Datenspeicheranwendungen beschrieben, bei denen die Hologramme unter Verwendung von Laserlicht im ultravioletten Bereich erzeugt werden. Die erhaltenen Hologramme sind nicht oder nur schlecht mit dem bloßen Auge zu erkennen. Nicht beschrieben sind hingegen Formulierungen mit deren Hilfe helle Hologramme erhalten werden können, die gut vom menschlichen Auge unmittelbar wahrgenommen werden können.

Will man helle und leicht sichtbare Hologramme herstellen, ist generell ein hoher Brechungsindexunterschied $\Delta n$ und eine geringe Dicke d des Mediums anzustreben und dies so, dass die Diffraction Efficiency DE möglichst groß wird. Das heißt, je höher $\Delta n$ wird, desto mehr Freiraum zur Gestaltung der Schichtdicke erlangt man ohne dass es zu einem Verlust an DE kommt. Aus diesem Grund kommt der Optimierung von $\Delta n$ bei der Herstellung von Photopolymer-Formulierungen für helle, sichtbare Hologramme eine herausragenden Bedeutung zu (P. Hariharan, Optical Holography, 2nd Edition, Cambridge University Press, 1996).

Aufgabe der vorliegenden Erfindung war es eine Photopolymer-Formulierung bereit zu stellen, in die schnell und einfach vom menschlichen Auge unmittelbar wahrnehmbare, helle Hologramme einbelichtet werden können.

Diese Aufgabe wird bei der erfindungsgemäßen Photopolymer-Formulierung dadurch gelöst, dass das Photoinitiatorsystem ein HABI, einen auf das HABI abgestimmten Farbstoff mit einem Absorptionsmaximum im Bereich von 400-800 nm und einen Wasserstoff-Donor enthält.

Unter HABI im Sinne der Erfindung werden Derivate des Hexaarylbisimidazols verstanden. Derartige Verbindungen sind beispielsweise in der US 3,652,275, der US 4,917,977 oder der US 4,963,471 beschrieben. Die hier beschriebenen Verbindungen können in der erfindungsgemäßen Photopolymer-Formulierung verwendet werden.

Unter einem Wasserstoff-Donor im Sinne der Erfindung werden Verbindungen verstanden, bei denen es leicht zu einer homolytischen Bindungsspaltung in ein Wasserstoff-Radikal und in ein gegebenenfalls stabilisiertes organisches Radikal mit erhöhter Lebensdauer und geringer Neigung zu Folgeraktionen wie Zerfall, Dimerisierung oder Addition kommt. Geeignete Wasserstoff-Donoren sind in der US 3,652,275, der US 4,917,977 oder der US 4,963,471 beschrieben. Die hier beschriebenen Wasserstoff-Donoren können in der erfindungsgemäßen Photopolymer-Formulierung verwendet werden.

Unter chemisch vernetzten Matrixpolymeren werden Polymere verstanden, bei denen die einzelnen Polymerketten durch kovalente Bindungen zu einem dreidimensionalen Netzwerk verknüpft sind.

Mit Hilfe der erfindungsgemäßen Photopolymer-Formulierungen können mit dem menschlichen Auge unmittelbar wahrnehmbare, helle Hologramme erhalten werden. Ein Nachprozessieren der Photopolymere ist dabei nicht erforderlich, was zu einer deutlich vereinfachten Herstellungsmöglichkeit für Volumenhologramme führt.

Gemäß einer bevorzugten Ausführungsform ist das HABI eine Verbindungen der Formel (I)

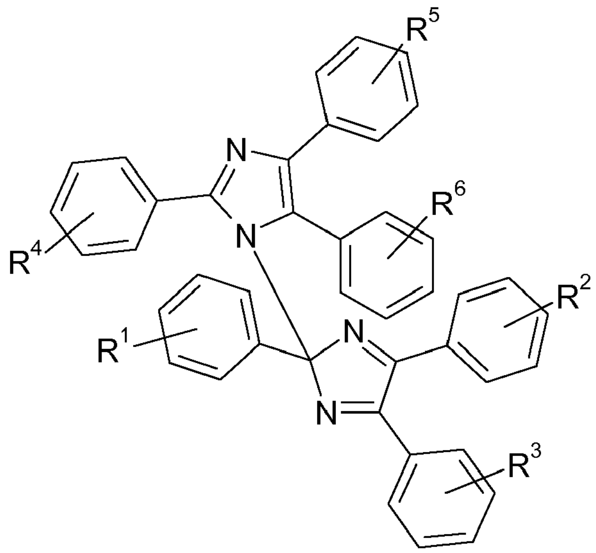

(I)

in der

| | |
|---|---|
| $R^1$, $R^4$ | jeweils unabhängig voneinander ein Chlor-, ein Methoxy- oder ein Ethoxy-Rest und |
| $R^2$, $R^3$, $R^5$, $R^6$ | jeweils unabhängig voneinander ein oder mehrere Wasserstoff-, Chlor-, Methoxy-, und/oder Ethoxy-Reste sind. |

Mit derartigen Photopolymer-Formulierungen können besonders helle Hologramme erhalten werden.

Noch weiter bevorzugt ist, wenn $R^1$ und $R^4$ jeweils ein Chlor-Rest und / oder $R^2$, $R^3$, $R^5$, $R^6$ jeweils ein Wasserstoff-Rest sind.

Der Wasserstoff-Donor kann aus der Gruppe Alkylamin, Alkylaminoalkohol, substituierter Glycin-Ester, aromatisches oder aliphatisches Thiol, aromatisches oder aliphatisches Amin, aromatisches oder benzylisches Disulfid, aromatisches oder benzylisches Diselenid ausgewählt sein.

Besonders bevorzugt ist allerdings, wenn der Wasserstoff-Donor 2-Mercapto-1-methylimidazol, 1-Phenyl-1H-tetrazole-5-thiol, Mercaptobenzothiazol, Phenyldisulfid, Dodecanethiol, 2(3H)-Benzoxazolethion, 1H-1,2,4-Triazole-3-thiol, 5,5'-Dithiobis-1-phenyl-1H-tetrazol, 1-Methyl-1H-tetrazole-5-thiol, 5-Methyl-1,3,4-thiadiazole-2-thiol, N-Phenylglycinethylester oder N-Phenylglycinmethylester ist. Es ist auch möglich, Gemische einzusetzen

Bei den chemisch vernetzten Matrixpolymeren kann es sich insbesondere um Polyurethane handeln.

Bei den Matrixpolymeren kann es sich vorzugsweise um Polyurethane handeln, die insbesondere durch Umsetzung von einer Isocyanatkomponente a) mit einer Isocyanat-reaktiven Komponente b) erhältlich sind.

Die Isocyanatkomponente a) umfasst bevorzugt Polyisocyanate. Als Polyisocyanate können alle dem Fachmann an sich bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendiisocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)methan und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat und/oder Triphenylmethan-4,4',4"-triisocyanat.

Ebenfalls möglich ist der Einsatz von Derivaten monomerer Di- oder Triisocyanate mit Urethan-, Harnstoff-, Carbodiimid-, Acylharnstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente a) um di- oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI sowie 1,8-Diisocyanato-4-(isocyanatomethyl)-octan oder deren Mischungen.

Ebenfalls können als Komponente a) NCO-funktionelle Prepolymere mit Urethan-, Allophanat-, Biuret- und/ oder Amidgruppen eingesetzt werden. Prepolymere der Komponente a) werden in dem Fachmann an sich gut bekannter Art und Weise durch Umsetzung von monomeren, oligomeren oder Polyisocyanaten a1) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Beispiele für geeignete monomere Di- oder Triisocyanate, die als Komponente a1) eingesetzt werden können, sind Butylendiisocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)-octan, Isocyanatomethyl-1,8-octandiisocyanat (TIN), 2,4- und/ oder 2,6-Toluen-diisocyanat.

Als isocyanatreaktive Verbindungen a2) zum Aufbau der Prepolymere werden bevorzugt OH-funktionelle Verbindungen eingesetzt. Diese sind analog den OH-funktionellen Verbindungen wie sie nachfolgend für die Komponente b) beschrieben sind.

Bevorzugte OH-funktionelle Verbindungen in a2) sind Polyester- und/oder Polyetherpolyole mit zahlenmittleren Molmassen von 200 bis 6200 g/Mol. Besonders bevorzugt sind difunktionelle Polyetherpolyole basierend auf Ethylenglykol und Propylenglykol, wobei der Propylenglykolanteil mindestens 40 Gew.-% ausmacht, sowie Polymere des Tetrahydrofurans mit zahlenmittleren Molmassen von 200 bis 4100 g/Mol sowie aliphatische Polyesterpolyole mit zahlenmittleren Molmassen von 200 bis 3100 g/Mol.

Ganz besonders bevorzugt sind difunktionelle Polyetherpolyole basierend auf Ethylenglykol und Propylenglykol, wobei der Propylenglykolanteil mindestens 80 Gew.-% ausmacht (insbesondere reine Polypropylenglykole), sowie Polymere des Tetrahydrofurans mit zahlenmittleren Molmassen von 200 bis 2100 g/Mol. Ganz besonders bevorzugt sind ebenso Additionsprodukte von Butyrolacton, ε-Caprolacton und/oder Methyl-ε-caprolacton (insbesondere ε-Caprolacton) an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen). Diese Additionsprodukte haben bevorzugt zahlenmittlere Molmassen von 200 bis 2000 g/Mol, besonders bevorzugt von 500 bis 1400 g/Mol.

Allophanate können auch im Gemisch mit anderen Prepolymeren oder Oligomeren der Komponente a1) eingesetzt werden. In diesen Fällen ist der Einsatz von OH-funktionellen Verbindungen mit Funktionalitäten von 1 bis 3,1 vorteilhaft. Beim Einsatz monofunktioneller Alkohole sind solche mit 3 bis 20 Kohlenstoffatomen bevorzugt.

Ebenfalls möglich ist der Einsatz von Aminen zur Prepolymerherstellung. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeff-amine®, aminterminierte Polymere mit zahlenmittleren Molmassen bis 10000 g/Mol oder deren beliebige Gemische untereinander.

Zur Herstellung von biuretgruppenhaltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art. Bevorzugt sind aliphatische Biurete auf Basis aliphatischer Amine und aliphatischer Isocyanate. Besonders bevorzugt sind niedermolekulare Biurete mit zahlenmittleren Molmassen kleiner 2000 g/Mol basierend auf aliphatischer Diaminen oder difunktionellen Polyaminen und aliphatischen Diisocyanaten, insbesondere HDI und TMDI.

Bevorzugte Prepolymere sind Urethane, Allophanate oder Biurete aus aliphatischen Isocyanat-funktionellen Verbindungen und oligomeren oder polymeren Isocyanat-reaktiven Verbindungen mit zahlenmittleren Molmassen von 200 bis 10000 g/Mol, besonders bevorzugt sind Urethane, Allophanate oder Biurete aus aliphatischen Isocyanat-funktionellen Verbindungen und Polyolen mit zahlenmittleren Molmassen von 200 bis 6200 g/Mol oder (Poly-)Aminen mit zahlenmittleren Molmassen kleiner 3000 g/Mol und ganz besonders bevorzugt sind Allophanate aus HDI oder TMDI und difunktionellen Polyetherpolyolen (insbesondere Polypropylenglykolen) mit zahlenmittleren Molmassen von 200 bis 2100 g/Mol, Urethane aus HDI oder TMDI auf Basis von Additionsprodukten von Butyrolacton, ε-Caprolacton und/oder Methyl-ε-caprolacton (insbesondere ε-Caprolacton) an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen) mit zahlenmittleren Molmassen von 500 bis 3000 g/Mol, insbesondere bevorzugt von 1000 bis 2000 g/Mol (insbesondere im Gemisch mit anderen Oligomeren difunktioneller aliphatischer Isocyanate) oder Urethane aus HDI oder TMDI auf Basis trifunktioneller Polyetherpolyole (insbesondere Polypropylenglykol) mit zahlenmittleren Molmassen zwischen 2000 und 6200 g/Mol sowie Biurete aus HDI oder TMDI mit difunktionellen Aminen oder

Polyaminen mit zahlenmittleren Molmassen von 200 bis 1400 g/Mol (insbesondere auch im Gemisch mit anderen Oligomeren difunktioneller aliphatischer Isocyanate).

Bevorzugt weisen die vorstehend beschriebenen Prepolymere Restgehalte an freiem monomeren Isocyanat von weniger als 2 Gew.-%, besonders bevorzugt weniger als 1,0 Gew.-%, ganz besonders bevorzugt weniger als 0,5 Gew.-% auf.

Selbstverständlich kann die Isocyanatkomponente anteilsmäßig neben den beschriebenen Prepolymeren weitere Isocyanatkomponenten enthalten. Hierfür kommen in Betracht aromatische, araliphatische, aliphatische und cycloaliphatische Di-, Tri- oder Polyisocyanate verwendet. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4-und/oder 2,4,4-Trimethylhexamethylendiisocyanat (TMDI), die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4"-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die Isocyanatkomponente a) anteilsmäßig Isocyanate enthält, die teilweise mit isocyanat-reaktiven ethylenisch ungesättigten Verbindungen umgesetzt sind. Bevorzugt werden hierbei als isocyanat-reaktives ethylenisch ungesättigten Verbindungen $\alpha,\beta$-ungesättigte Carbonsäurederivate wie Acrylate, Methacrylate, Maleinate, Fumarate, Maleimide, Acrylamide, sowie Vinylether, Propenylether, Allylether und Dicyclopentadienyl-Einheiten enthaltende Verbindungen, die mindestens eine gegenüber Isocyanaten reaktive Gruppe aufweisen, eingesetzt, besonders bevorzugt sind dies Acrylate und Methacrylate mit mindestens einer isocyanatreaktiven Gruppe. Als hydroxyfunktionelle Acrylate oder Methacrylate kommen beispielsweise Verbindungen wie 2-Hydroxyethyl(meth) acrylat, Polyethylenoxid-mono(meth)acrylate, Polypropylenoxidmono(meth)acrylate, Polyalkylenoxidmono-(meth)acrylate, Poly($\varepsilon$-caprolacton)mono(meth)acrylate, wie z.B. Tone® M100 (Dow, USA), 2-Hydroxypropyl(meth)acrylat, 4-Hydroxybutyl(meth)acrylat, 3-Hydroxy-2,2-dimethylpropyl(meth)acrylat, die hydroxyfunktionellen Mono-, Di- oder Tetra (meth)acrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische in Betracht. Darüberhinaus sind isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Der Anteil an Isocyanaten die teilweise mit isocyanat-reaktiven ethylenisch ungesättigten Verbindungen umgesetzt sind an der Isocyanatkomponente a) beträgt 0 bis 99 %, bevorzugt 0 bis 50 %, besonders bevorzugt 0 bis 25 % und ganz besonders bevorzugt 0 bis 15 %.

Es ist gegebenenfalls auch möglich, dass die vorgenannten Isocyanatkomponente a) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, $\varepsilon$-Caprolactam, N-tert.-Butyl-benzylamin, Cyclopentanoncarboxyethylester oder beliebige Gemische dieser Blockierungsmittel.

Als Komponente b) können an sich alle polyfunktionellen, isocyanatreaktiven Verbindungen eingesetzt werden, die im Mittel wenigstens 1.5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Daneben sind als Bestandteile der Komponente b) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di, tri oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure (2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit,

Dipentaerythrit oder Sorbit.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität $\geq 2$ erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für solche geeigneten Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Bevorzugte Polyesterpolyole basieren auf aliphatischen Alkoholen und Mischungen aus aliphatischen und aromatischen Säuren und haben zahlenmittlere Molmassen zwischen 500 und 10000 g/Mol und Funktionalitäten zwischen 1,8 und 6,1.

Besonders bevorzugte Polyesterpolyole basieren auf aliphatischen Diolen wie Butan-1,4-diol, Hexan-1,6-diol, Neopentylglykol, Ethandiol, Propylenglykol, 1,3-Butylenglykol, Di-, Tri-, Polyethylenglykol, Di-, Tri- und/oder Tetrapropylenglykol oder Mischungen aus vorgenannten Diolen mit aliphatischen höherfunktionellen Alkoholen wie Trimethylolpropan und/oder Pentaerythrit, wobei der Anteil der höherfunktionellen Alkohole bevorzugt kleiner 50 Gewichtsprozent (insbesondere bevorzugt kleiner 30 Gewichtsprozent) bezogen auf die Gesamtmenge des eingesetzten Alkohols ausmacht, in Verbindung mit aliphatischen Di- bzw. Polycarbonsäuren bzw. Anhydriden wie Adipinsäure und/oder Bernsteinsäure oder Mischungen aus vorgenannten aliphatischen Polycarbonsäuren bzw. Anhydriden mit aromatischen Polycarbonsäuren bzw. Anhydriden wie Terephthalsäure und/oder Isophthalsäure wobei der Anteil der aromatischen Polycarbonsäuren bzw. Anhydride bevorzugt kleiner 50 Gewichtsprozent (insbesondere bevorzugt kleiner 30 Gewichtsprozent) bezogen auf die Gesamtmenge der eingesetzten Polycarbonsäuren bzw. Anhydride ausmacht. Besonders bevorzugte Polyesterpolyole haben zahlenmittlere Molmassen zwischen 1000 und 6000 g/Mol und Funktionalitäten zwischen 1,9 und 3,3.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen im Rahmen einer ringöffnenden Lacton-Polymerisation wie Butyrolacton, ε-Caprolacton und/oder Methyl-ε-caprolacton an hydroxyfunktionelle Verbindungen wie mehrwertige Alkohole einer OH-Funktionalität $\geq 2$ oder Polyole eine Funktionalität von größer 1,8 beispielsweise der vorstehend genannten Art erhalten werden können.

Bevorzugte Polyole, die hier als Starter eingesetzt werden, sind Polyetherpolyole einer Funktionalität von 1,8 bis 3,1 mit zahlenmittleren Molmassen von 200 bis 4000 g/mol, besonders bevorzugt sind Poly(tetrahydrofurane) mit einer Funktionalität von 1,9 bis 2,2 und zahlenmittleren Molmassen von 500 bis 2000 g/mol (insbesondere 600 bis 1400 g/mol). Als Anlagerungsprodukte sind Butyrolacton, ε-Caprolacton und/oder Methyl-ε-caprolacton, ε-Caprolacton ist besonders bevorzugt.

Solche Polyesterpolyole haben bevorzugt zahlenmittlere Molmassen von 400 bis 6000 g/Mol, besonders bevorzugt von 800 bis 3000 g/Mol. Ihre OH-Funktionalität beträgt bevorzugt 1.8 bis 3.5, besonders bevorzugt 1.9 bis 2.2.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität $\geq 2$, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2000 g/Mol. Die OH-Funktionalität dieser Polyole beträgt bevorzugt 1.8 bis 3.2, besonders bevorzugt 1.9 bis 3.0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität $\geq 2$ sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alykenoxidanteil nicht höher als 80 Gew.-% ist. Besonders bevorzugt sind Propylenoxid-homopolymere sowie statistische oder

Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen- und Oxybutyleneinheiten mindestens 20 Gew.-%, bevorzugt mindestens 45 Gew.-% ausmacht. Oxypropylen- und Oxybutylen- umfasst hierbei alle jeweiligen linearen und verzweigten C3- und C4-Isomere.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1.5 bis 4.0, besonders bevorzugt 1.8 bis 3.1 und ganz besonders bevorzugt 1.9 bis 2.2.

Als spezielle Polyetherpolyole werden bevorzugt solche eingesetzt, die aus einer isocyanatreaktiven Komponente umfassend hydroxyfunktionelle Multiblockcopolymere des Typs $Y(X_i\text{-}H)_n$ mit i = 1 bis 10 und n = 2 bis 8 und zahlenmittleren Molekulargewichten von größer 1500 g/Mol bestehen, wobei die Segmente $X_i$ jeweils aus Oxyalkyleneinheiten der Formel II aufgebaut sind,

-CH2-CH(R)-O- (II)

wobei R ein Wasserstoff-, Alkyl-, oder Arylrest, ist, der auch substituiert oder durch Heteroatome (wie Ethersauerstoffe) unterbrochen sein kann, Y der zugrundeliegende Starter ist und der Anteil der Segmente $X_i$ bezogen auf die Gesamtmenge der Segmente $X_i$ und Y wenigstens 50 Gew.-% ausmacht.

Die äußeren Blöcke $X_i$ machen dabei zumindest 50 Gew.-%, bevorzugt 66 Gew.-% der Gesamtmolmasse von $Y(X_i\text{-}H)_n$ aus und bestehen aus Monomereinheiten, die der Formel II gehorchen. Bevorzugt ist n in $Y(X_i\text{-}H)_n$ eine Zahl von 2 bis 6, besonders bevorzugt 2 oder 3 und ganz besonders bevorzugt gleich 2. Bevorzugt ist i in $Y(X_i\text{-}H)_n$ eine Zahl von 1 bis 6, besonders bevorzugt von 1 bis 3 und ganz besonders bevorzugt gleich 1.

In Formel II ist R bevorzugt ein Wasserstoff, eine Methyl-, Butyl-, Hexyl- oder Octylgruppe oder ein ethergruppenhaltiger Alkylrest. Bevorzugte ethergruppenhaltiger Alkylreste sind solche basierend auf Oxyalkyleneinheiten.

Die Multiblockcopolymere $Y(X_i\text{-}H)_n$ haben bevorzugt zahlenmittlere Molekulargewichte von mehr als 1200 g/Mol, besonders bevorzugt mehr als 1950 g/Mol, jedoch bevorzugt nicht mehr als 12000 g/Mol, besonders bevorzugt nicht mehr als 8000 g/Mol.

Die Blöcke $X_i$ können Homopolymere aus ausschließlich gleichen Oxyalkylen-Wiederholungseinheiten sein. Sie können auch statistisch aus verschiedenen Oxyalkyleneinheiten oder ihrerseits blockweise aus verschiedenen Oxyalkyleneinheiten aufgebaut sein.

Bevorzugte basieren die Segmente $X_i$ ausschließlich auf Propylenoxid oder statistischen oder blockweisen Mischungen von Propylenoxid mit weiteren 1-Alkylenoxiden, wobei der Anteil an weiteren 1-Alykenoxiden nicht höher als 80 Gew.-% ist.

Besonders bevorzugt sind als Segmente $X_i$ Propylenoxid-homopolymere sowie statistische oder Block-Copolymere, die Oxyethylen- und/oder Oxypropyleneinheiten, wobei der Anteil der Oxypropyleneinheiten bezogen auf die Gesamtmenge aller Oxyethylen- und Oxypropyleneinheiten mindestens 20 Gew.-%, bevorzugt mindestens 40 Gew.-% ausmacht.

Die Blöcke $X_i$ werden wie weiter unten beschrieben durch ringöffnende Polymerisation der vorstehend beschriebenen Alkylenoxide auf einen n-fach hydroxy- oder aminofunktionellen Starterblock $Y(H)_n$ aufaddiert.

Der innere Block Y, der zu kleiner 50 Gew.-%, bevorzugt aus kleiner 34 Gew.-% in $Y(X_i\text{-}H)_n$ enthalten ist, besteht aus di- und/oder höher hydroxyfunktionellen Polymerstrukturen auf Basis cyclischer Ether oder ist aufgebaut aus di- und/oder höher hydroxyfunktionellen Polycarbonat-, Polyester-, Poly(meth)acrylat-, Epoxydharz- und/oder Polyurethanstruktureinheiten oder entsprechenden Hybriden.

Geeignete Polyesterpolyole sind lineare Polyesterdiole oder verzweigte Polyesterpolyole, wie sie in bekannter Weise aus aliphatischen, cycloaliphatischen oder aromatischen Di- bzw. Polycarbonsäuren bzw. ihren Anhydriden wie z. B. Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebiger Gemische mit mehrwertigen Alkoholen wie z. B. Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12 oder deren Gemische gegebenenfalls unter Mitverwendung höherfunktioneller Polyole wie Trimethylolpropan oder Glycerin hergestellt werden können. Als mehrwertige Alkohole zur Herstellung der Polyesterpolyole kommen natürlich auch cycloaliphatische und/oder aromatische Di- und Polyhydroxylverbindungen in Frage. Anstelle der freien Polycarbonsäure können auch die entsprechenden Polycarbonsäureanhydride oder entsprechende Polycarbonsäureester von niedrigen Alkoholen oder deren Gemische zur Herstellung der Polyester verwendet werden.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität von bevorzugt 2, beispielsweise der vorstehend genannten Art, erhalten werden können.

Solche Polyesterpolyole haben bevorzugt zahlenmittlere Molmassen von 200 bis 2000 g/Mol, besonders bevorzugt von 400 bis 1400 g/Mol.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyesterpolyole genannten mehrwertigen Alkohole einer OH-Funktionalität von 2, bevorzugt 1,4-Butandiol, 1,6-Hexandiol und/oder 3-Methylpentandiol. Polyesterpolyole können auch zu Polycarbonatpolyolen umgearbeitet werden. Besonders bevorzugt werden bei der Umsetzung der genannten Alkohole zu Polycarbonatpolyolen Dimethyl- oder Diethylcarbonat eingesetzt.

Solche Polycarbonatpolyole haben bevorzugt zahlenmittlere Molmassen von 400 bis 2000 g/Mol, besonders bevorzugt von 500 bis 1400 g/Mol und ganz besonders bevorzugt von 650 bis 1000 g/Mol.

Geeignete Polyetherpolyole sind gegebenenfalls blockweise aufgebaute Polyadditionsprodukte cyclischer Ether an OH- oder NH-funktionelle Startermoleküle. Als Polyetherpolyole seien z. B. die Polyadditionsprodukte der Styroloxide, des Ethylenoxid, Propylenoxid, Tetrahydrofuran, Butylenoxid, Epichlorhydrins, sowie ihre Mischadditions- und Pfropfprodukte, sowie die durch Kondensation von mehrwertigen Alkoholen oder Mischungen derselben und die durch Alkoxylierung von mehrwertigen Alkoholen, Aminen und Aminoalkoholen gewonnenen Polyetherpolyole.

Geeignete Polymere cyclischer Ether sind insbesondere Polymere des Tetrahydrofuran.

Als Starter können die an sich im Rahmen der Polyesterpolyole genannten mehrwertigen Alkohole sowie primäre oder sekundäre Amine und Aminoalkohole einer OH- oder NH-Funktionalität von 2 bis 8, bevorzugt 2 bis 6, besonders bevorzugt 2 bis 3, ganz besonders bevorzugt gleich 2 verwendet werden.

Solche Polyetherpolyole haben bevorzugt zahlenmittlere Molmassen von 200 bis 2000 g/Mol, besonders bevorzugt von 400 bis 1400 g/Mol und ganz besonders bevorzugt von 650 bis 1000 g/Mol.

Als für Starter verwendete Polyetherpolyole werden bevorzugt die Polymere des Tetrahydrofuran eingesetzt.

Selbstverständlich können auch Mischungen der oben beschriebenen Komponenten für den inneren Block Y eingesetzt werden.

Bevorzugte Komponenten für den inneren Block Y sind Polymere des Tetrahydrofuran sowie aliphatische Polycarbonatpolyole und Polyesterpolyole sowie Polymere des ε-Caprolacton mit zahlenmittleren Molmassen kleiner 3100 g/Mol.

Besonders bevorzugte Komponenten für den inneren Block Y sind difunktionelle Polymere des Tetrahydrofuran sowie difunktionelle aliphatische Polycarbonatpolyole und Polyesterpolyole sowie Polymere des ε-Caprolacton mit zahlenmittleren Molmassen kleiner 3100 g/Mol.

Ganz besonders bevorzugt basiert das Startersegment Y auf difunktionellen, aliphatischen Polycarbonatpolyolen, Poly(ε-Caprolacton) oder Polymeren des Tetrahydrofurans mit zahlenmittleren Molmassen größer 500 g/Mol und kleiner 2100 g/Mol.

Bevorzugt eingesetzte Blockcopolymere der Struktur $Y(X_i\text{-}H)_n$ bestehen zu mehr als 50 Gewichtsprozent aus den oben als beschriebenen Blöcken $X_i$ und haben eine zahlenmittlere Gesamtmolmasse von größer 1200 g/Mol.

Besonders bevorzugte Blockcopolyole bestehen zu weniger als 50 Gewichtsprozent aus aliphatischem Polyester, aliphatischem Polycarbonatpolyol oder Poly-THF und zu mehr als 50 Gewichtsprozent aus den oben als erfindungsgemäß beschriebenen Blöcken $X_i$ und haben eine zahlenmittlere Molmasse von größer 1200 g/Mol. Besonders bevorzugte Blockcopolymere bestehen bestehen zu weniger als 50 Gewichtsprozent aliphatischem Polycarbonatpolyol, Poly(ε-Caprolacton) oder Poly-THF und zu mehr als 50 Gewichtsprozent aus den oben als erfindungsgemäß beschriebenen Blöcken $X_i$ und haben eine zahlenmittlere Molmasse von größer 1200 g/Mol.

Ganz besonders bevorzugte Blockcopolymere bestehen zu weniger als 34 Gewichtsprozent aus aliphatischem Polycarbonatpolyol, Poly(ε-Caprolacton) oder Poly-THF und zu mehr als 66 Gewichtsprozent aus den oben als erfindungsgemäß beschriebenen Blöcken $X_i$ und haben eine zahlenmittlere Molmasse von größer 1950 g/Mol und weniger als 9000 g/Mol.

Die beschriebenen Blockcopolyole werden durch Alkylenoxidadditionsverfahren hergestellt. Von großtechnischer Bedeutung ist zum einen die basisch katalysierte Anlagerung von Alkylenoxiden an Starterverbindungen mit Zerewitinoff-aktiven Wasserstoffatomen $Y(H)_n$, zum anderen die gewinnt die Verwendung von Doppelmetallcyanidverbindungen ("DMC-Katalysatoren") für die Durchführung dieser Reaktion zunehmend an Bedeutung. An N, O oder S gebundener Wasserstoff wird als Zerewitinoff-aktiver Wasserstoff (manchmal auch nur als "aktiven Wasserstoff") bezeichnet, wenn er nach einem von Zerewitinoff aufgefundenen Verfahren durch Umsetzung mit Methylmagnesiumjodid Methan liefert. Typische Beispiele für Verbindungen mit Zerewitinoff-aktivem Wasserstoff sind Verbindungen, die Carboxyl-, Hydroxyl-, Amino-, Imino- oder Thiol-Gruppen als funktionelle Gruppen enthalten. Die basisch katalysierte Anlagerung von Alkylenoxiden wie beispielsweise Ethylenoxid oder Propylenoxid an Starterverbindungen mit Zerewitinoff-aktiven Wasserstoffatomen erfolgt in Gegenwart von Alkalimetallhydroxiden, es können aber auch Alkalimetallhydride,

Alkalimetallcarboxylate oder Erdalkalihydroxide verwendet werden. Nach erfolgter Anlagerung der Alkylenoxide müssen die polymerisationsaktiven Zentren an den Polyetherketten deaktiviert werden, beispielsweise durch Neutralisation mit verdünnten Mineralsäuren wie Schwefelsäure oder Phosphorsäure und Abtrennung der entstehenden Salze. Im erfindungsgemäßen Verfahren werden bevorzugt DMC-Katalysatoren verwendet. Besonders bevorzugt eingesetzt werden hochaktive DMC-Katalysatoren, die z.B. beschrieben sind in US-A 5 470 813, EP-A 700 949, EP-A 743 093, EP-A 761 708, WO 97/40086, WO 98/16310 und WO 00/47649. Ein typisches Beispiel sind die in EP-A 700 949 beschriebenen hochaktiven DMC-Katalysatoren, die neben einer Doppelmetallcyanid-Verbindung (z.B. Zinkhexacyanocobaltat(III)) und einem organischen Komplexliganden (z.B. tert.-Butanol) noch einen Polyether mit einem zahlenmittlerem Molekulargewicht größer als 500 g/Mol enthalten. Diese Katalysatoren können aufgrund ihrer hohen Aktivität in solch kleinen Mengen eingesetzt werden, dass eine weitere Aufarbeitung der Polyetherpolyole nicht erforderlich ist. Das Verfahren ist unten ausführlicher beschrieben. Als "Starterpolyol" wird dabei stets die zu weniger als 50 Gewichtsprozent im Blockcopolymer enthaltene OH-funktionalisierte Vorstufe Y eingesetzt, auf die Alkylenoxid aufpolymerisiert witrd, so dass am Ende ein Multiblockcopolymer erhalten wird. Als Alkylenoxide kommen bevorzugt Ethylenoxid, Propylenoxid, Butylenoxid sowie deren Mischungen zum Einsatz. Der Aufbau der Polyetherketten durch Alkoxylierung kann z.B. nur mit einem monomeren Epoxid durchgeführt werden oder auch statistisch oder blockweise mit mehreren unterschiedlichen monomeren Epoxiden erfolgen.

Gemäß einer weiteren bevorzugten Ausführungsform ist vorgesehen, dass die Schreibmonomere ein mono- und / oder ein multifunktionales Schreibmonomer umfassen, wobei es sich insbesondere um ein mono- und / oder ein multifunktionelles Acrylat handeln kann. Die Verwendung dieser Schreibmomomere und vor allem der Schreibmonomerkombination führt zu einer weiteren Erhöhung der Helligkeit der Hologramme.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p-Chlorphenylacrylat, p-Chlorphenylmethacrylat, p-Bromphenylacrylat, p-Bromphenyl-methacrylat, 2,4,6-Trichlorphenylacrylat, 2,4,6-Trichlorphenylmethacrylat, 2,4,6-Tribromphenyl-acrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, Phenylthioethylacrylat, Phenylthioethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate, um nur eine Auswahl verwendbarer Acrylate und Methacrylate zu nennen.

Weiter bevorzugt ist, wenn das Acrylat die allgemeine Formel (III)

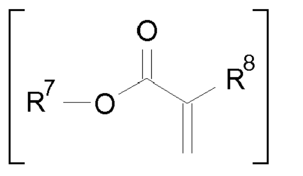

(III)

hat, in der m≥1 und m≤4 ist und $R^7$, $R^8$ unabhängig voneinander Wasserstoff, lineare, verzweigte, cyclische oder heterocyclische unsubstituierte oder gegebenenfalls auch mit Heteroatomen substituierte organische Reste sind.

Selbstverständlich können auch Urethanacrylate verwendet werden. Unter Urethanacrylaten versteht man Verbindungen mit mindestens einer Acrylsäureestergruppe, die zusätzlich über mindestens eine Urethanbindung verfügen. Es ist bekannt, dass solche Verbindungen durch Umsetzung eines Hydroxy-funktionellen Acrylsäureesters mit einer Isocyanat-funktionellen Verbindung erhalten werden können.

Beispiele hierfür verwendbarer Isocyanat-funktionelle Verbindungen sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, m-Methylthiophenylisocyanat, Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise Verbindungen in Betracht wie 2-Hydroxyethyl(meth)acrylat, Polyethylenoxid-mono(meth)acrylate, Polypropylenoxidmono(meth)acrylate, Polyalkylenoxidmono-(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono(meth)acrylate. Darüber hinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten.

Bevorzugt sind insbesondere Urethanacrylate erhältlich aus der Umsetzung von Tris(p-isocyanatophenyl)thiophosphat und m-Methylthiophenylisocyanat mit alkoholfunktionellen Acrylaten wie Hydroxyethyl(meth)acrylat, Hydroxypropyl(meth)acrylat und Hydroxybutyl(meth)acrylat.

Ebenso ist es möglich, dass weitere ungesättigte Verbindungen wie α,β-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol, Olefinine, wie z.B. 1-Octen und/oder 1-Decen, Vinylestern, (Meth)acrylnitril, (Meth)acrylamid, Methacrylsäure, Acrylsäure als Schreibmonomere zugesetzt werden.

Die Photopolymer-Formulierung kann auch zusätzlich Urethane als Weichmacher enthält, wobei die Urethane insbesondere mit wenigstens einem Fluoratom substituiert sein können. Besonders vorteilhaft ist, wenn die Urethane die allgemeine Formel (IV)

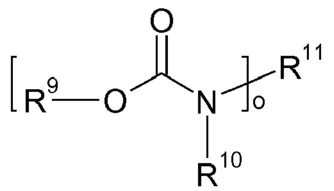

(IV)

haben, in der o≥1 und o≤8 ist und $R^9$, $R^{10}$, $R^{11}$ unabhängig voneinander Wasserstoff lineare, verzweigte, cyclische oder heterocyclische unsubstituierte oder gegebenenfalls auch mit Heteroatomen substituierte organische Reste sind, wobei bevorzugt mindestens einer der Reste $R^9$, $R^{10}$, $R^{11}$ mit wenigstens einem Fluoratom substituiert ist und besonders bevorzugt $R^9$ ein organischer Rest mit mindestens einem Fluoratom ist. Derartige Formulierungen führen zu noch helleren Hologrammen.

Die Photopolymer-Formulierung enthält einen oder mehrere Farbstoffe, dessen Absorptionsspektrum mit der Emission des zum Schreiben des Hologramms verwendeten Lasers hinreichend übereinstimmt, als Sensibilisator. Dabei kommt dem Farbstoff die Rolle zu, die Lichtenergie aufzunehmen und durch nachgelagerte Prozesse an das HABI zu übergeben (R. Dessauer, Advances in Photochemistry (2005), 28, 129). Es ist anzumerken, dass HABIs nicht nur durch Farbstoffe, sondern auch durch andere externe Stimuli wie Temperatur oder Druck vom dimeren in den monomeren Zustand wechseln und anschliessend Folgereaktionen eingehen bzw. auslösen können. Geeignete Farbstoffe sind aus den Klassen der Aminotriarylmethane, Triarylmethane, Hydrochinonether, Acridine, Phenazine, Phenothiazine, Pyrene, Polymethine, Diphenylmethane, Coumarine auszuwählen, wobei das Absorptionsmaximum im Bereich von 400-800 nm liegt.

Bevorzugte Farbstoffe sind Astrazon Orange G (Basic Orange 21) und /oder Ketocoumarin.

Weitere Bestandteile der Photopolymer-Formulierung können sein: Radikalstabilisatoren, gegenenfalls Katalysatoren oder andere Hilfs- und Zusatzstoffe.

Die erfindungsgemäßen Photopolymer-Formulierungen können insbesondere zur Herstellung eines holographischen Mediums in Form eines Films verwendet werden. Dabei wird als Träger eine Lage eines für Licht im sichtbaren Spektralbereich (Transmission größer als 85% im Wellenlängenbereich von 400 bis 780 nm) transparenten Materials oder Materialverbunds ein- oder beidseitig mit einer Lage aus der Photopolymer-Formulierung beschichtet sowie ggf. eine Abdeckschicht auf der oder den Photopolymerlagen appliziert.

Bevorzugte Materialien oder Materialverbünde des Trägers basieren auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Besonders bevorzugt basieren sie auf PC, PET und CTA. Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders bevorzugt sind PC/PET, PET/PC/PET und PC/TPU (TPU = Thermoplastisches Polyurethan).

Alternativ zu den vorgenannten Kunststoffträgern können auch planare Glasplatten eingesetzt werden, die insbesondere für großflächige abbildungsgenaue Belichtungen Verwendung finden, z.B. für holographische Lithographie (Ng, Willie W.; Hong, Chi-Shain; Yariv, Amnon. Holographic interference lithography for integrated optics. IEEE Transactions on Electron Devices (1978), ED-25(10), 1193-1200, ISSN:0018-9383).

Die Materialien oder Materialverbünde des Trägers können einseitig oder beidseitig antihaftend, antistatisch, hydrophobiert oder hydrophiliert ausgerüstet sein. Die genannten Modifikationen dienen an der Photopolymerlage zugewandten Seite dem Zweck, dass die Photopolymerlage von dem Träger zerstörungsfrei abgelöst werden kann. Eine Modifikation der der Photopolymerlage abgewandten Seite des Trägers dient dazu, dass die erfindungsgemäßen Medien speziellen mechanischen Anforderungen genügen, die z.B. bei der Verarbeitung in Rollenlaminatoren, insbesondere bei Rolle-zu-Rolle-Verfahren, gefordert sind.

Ein weiterer Gegenstand der Erfindung ist daher die Verwendung einer erfindungsgemäßen Photopolymer-Formulierung zur Herstellung holographischer Medien, insbesondere zur Herstellung von In-Line Hologrammen, Off-Axis Hologrammen, Full-Aperture Transfer Hologrammen, Weißlicht-Transmissionshologrammen, Denisyukhologrammen, Off-Axis Reflektionshologrammen, Edge-Lit Hologrammen sowie holographischen Stereogrammen.

Schließlich ist auch ein Verfahren zur Herstellung von belichteten holographischen Medien, bei dem ein holographisches Medium aus einer Photopolymer-Formulierung gemäß einem der Ansprüche 1 bis 11 hergestellt und in das Medium mit elektromagnetischer Strahlung ein Hologramm einbelichtet wird Gegenstand der Erfindung.

Mögliche optische Funktionen der Hologramme, die mit den erfindungsgemäßen Photopolymer-Formulierungen hergestellt werden können entsprechen den optische Funktionen von Lichtelementen wie Linsen, Spiegel, Umlenkspiegel, Filter, Streuscheiben, Beugungselemente, Lichtleiter, Lichtlenker (waveguides), Projektionsscheiben und/oder Masken. Häufig zeigen diese optischen Elemente eine Frequenzselektivität, je nachdem wie die Hologramme belichtet wurden und welche Dimensionen das Hologramm hat.

Zudem können mittels der erfindungsgemäßen Photopolymer-Formulierungen auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellen Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

## Beispiele

Die Erfindung wird im Folgenden näher anhand von Beispielen näher erläutert.

## Einsatzstoffe:

Isocyanatkomponente 1 ist ein Produkt der Bayer MaterialScience AG, Leverkusen, Deutschland, Vollallophanat von Hexandiisocyanat auf Polypropylenglykol mit zahlenmittlerer Molmasse von ca. 280 g/mol, NCO-Gehalt: 16,5 - 17,3 %.

Polyol 1 ist ein experimentelles Produkt der Bayer MaterialScience AG, Leverkusen, Deutschland, die Herstellung ist unten beschrieben.

DMC-Katalysator: Doppelmetallcyanid-Katalysator auf Basis Zinkhexacyanocobaltat (III), erhältlich nach dem in EP-A 700 949 beschriebenen Verfahren.

Irganox 1076 ist Octadecyl 3,5-di-(tert)-butyl-4-hydroxyhydrocinnamate (CAS 2082-79-3).

Acrylat 1 ist ein experimentelles Produkt der Bayer MaterialScience AG, Leverkusen, Deutschland, die Herstellung ist unten beschrieben.

Acrylat 2 ist ein experimentelles Produkt der Bayer MaterialScience AG, Leverkusen, Deutschland, die Herstellung ist unten beschrieben.

Additiv 1 ist ein experimentelles Produkt der Bayer MaterialScience AG, Leverkusen, Deutschland, die Herstellung ist unten beschrieben.

Katalysator 1: Urethanisierungskatalysator, Dimethylbis[(1-oxoneodecl)oxy]stannan, Handelsprodukt der Momentive Performance Chemicals, Wilton, CT, USA (als 10%ige Lösung in N-Ethylpyrrolidon eingesetzt).

Coinitiator 1 ist 1H-Imidazol-2-(2-Chlorophenyl)-1-[2-(2-Chlorophenyl)-4,5-Diphenyl-2H-Imidazol-2-yl]-4,5-diphenyl und wurde von der ABCR GmbH & Co. KG, Karlsruhe, Deutschland, bezogen (CAS: 7189-82-4).

Coinitiator 2 ist 2-Mercaptobenzoxazol und wurde von der Sigma-Aldrich Chemie GmbH, Steinheim, Deutschland, bezogen (CAS: 2382-96-9).

Farbstoff 1 ist Ketocoumarin und wurde von Acros Organics, New Jersey, USA, bezogen (CAS: 63226-13-1).

Farbstoff 2 ist Astrazon Orange G und wurde von der Sigma-Aldrich Chemie GmbH, Steinheim, Deutschland, bezogen (CAS: 3056-93-7).

## Messmethoden:

Die angegebenen OH-Zahlen wurden gemäß DIN 53240-2 bestimmt.

Für die Bestimmung der Viskosität wurde die zu untersuchende Komponente oder Mischung bei 20°C in einem Kegel Platte Messsystem eines Rheometers (Firma Anton Paar Physica Modell MCR 51) aufgetragen. Die Messung wird bei folgenden Bedingungen durchgeführt:

- Messkörper: Kegel CP 25, d = 25mm, Winkel = 1° °
- Messspalt als Abstand zwischen Kegel und Platte: 0,047 mm
- Messdauer: 10 sec.
- Bestimmung der Viskosität bei einer Scherrate von 250 1/sec.

Messung der holographischen Eigenschaften DE und $\Delta n$ der holographischen Medien mittels Zweistrahlinterferenz in Reflexionsanordnung

Die wie unten beschrieben hergestellten holographischen Medien wurden anschließend mittels einer Messanordnung gemäß Figur 1 wie folgt auf ihre holographischen Eigenschaften geprüft:

Der Strahl eines diodengepumpten Festkörperlasers der Firma Newport, Modell EXLSR-473-50-CDRH, wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die $\lambda/2$ Plättchen wurden die Leistung des Referenzstrahls auf 1.55 mW und die Leistung des Signalstrahls auf 1.96 mW eingestellt. Die Leistungen wurden mit den Halbleiterdetektoren (D) bei ausgebauter Probe bestimmt. Der Einfallswinkel ($\alpha_0$) des Referenzstrahls beträgt -22°, der Einfallswinkel ($\beta_0$) des Signalstrahls beträgt 42°. Die Winkel werden ausgehend von der Probennormale zur Strahlrichtung gemessen. Gemäß Figur 1 hat daher $\alpha_0$ ein negatives Vorzeichen und $\beta_0$ ein positives Vorzeichen. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand Λ, auch Gitterperiode genannt, im Medium beträgt ~ 164 nm (der Brechungsindex des Mediums zu ~1.515 angenommen).

Figur 1 zeigt die Geometrie eines Holographic Media Testers (HMT) bei $\lambda$ = 473 nm (diodengepumpten Festkörperlasers der Firma Newport, Modell EXLSR-473-50-CDRH): M = Spiegel, S = Verschluss, SF = Raumfilter, CL = Kollimatorlinse, $\lambda/2$ = $\lambda/2$ Platte, PBS = polarisationsempfindlicher Strahlteiler, D = Detektor, I = Irisblende, $\alpha_0$ = -22°, $\beta_0$ = 42° sind die Einfallswinkel der kohärenten Strahlen außerhalb der Probe (des Mediums) gemessen. RD = Referenzrichtung des Drehtisches.

Es wurden auf folgende Weise Hologramme in das Medium geschrieben:

- Beide Shutter (S) sind für die Belichtungszeit *t* geöffnet.
- Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel ($\Omega$) des Mediums der Strahl immer vollständig im zuvor geschriebenen Hologramm lag. Der Drehtisch überstrich nun computergesteuert den Winkelbereich von $\Omega_{min}$ bis $\Omega_{max}$ mit einer Winkelschrittweite von 0.05°. $\Omega$ wird von der Probennormale zur Referenzrichtung des Drehtisches gemessen. Die Referenzrichtung des Drehtisches ergibt sich dann wenn beim Schreiben des Hologramms der Einfallswinkel des Referenz- und des Signalstrahls betragsmäßig gleich sind also $\alpha_0$ = -32° und $\beta_0$ = 32° gilt. Dann beträgt $\Omega_{recording}$ = 0°.

Für $\alpha_0$ = -22° und $\beta_0$ = 42° beträgt $\Omega_{recording}$ daher 10°. Allgemein gilt für das Interferenzfeld beim Schreiben ("recording") des Hologramms:

$$\alpha_0 = \theta_0 + \Omega_{recording}.$$

$\theta_0$ ist der Halbwinkel im Laborsystem außerhalb des Mediums und es gilt beim Schreiben des Hologramms:

$$\theta_0 = \frac{\alpha_0 - \beta_0}{2}.$$

In diesem Fall gilt also $\theta_0$ = -32°. An jedem angefahrenen Drehwinkel $\Omega$ wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz ergab sich bei jedem angefahrenen Winkel $\Omega$ als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels $\Omega$ des geschriebenen Hologramms gemessen und in einem Computer gespeichert. Zusätzlich wurde auch die in die nullte Ordnung transmittierte Intensität gegen den Drehwinkel $\Omega$ aufgezeichnet und in einem Computer gespeichert.

Die maximale Beugungseffizienz (DE = $\eta_{max}$) des Hologramms, also sein Spitzenwert, wurde bei $\Omega_{reconstruction}$ ermittelt. Eventuell musste dazu die Position des Detektors des abgebeugten Strahls verändert werden, um diesen maximalen Wert zu bestimmen.

Der Brechungsindexkontrast $\Delta n$ und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Dabei ist zu beachten, dass wegen der durch die Photopolymerisation auftretenden Dickenschwindung der Streifenabstand Λ' des Hologramms und die Orientierung der Streifen (slant) vom Streifenabstand Λ des Interferenzmusters und dessen Orientierung abweichen kann. Demnach wird auch der Winkel $\alpha_0'$ bzw. der entsprechende Winkel des Drehtisches $\Omega_{reconstruction}$, bei dem maximale Beugungseffizienz erreicht wird von $\alpha_0$ bzw. vom entsprechenden $\Omega_{recording}$ abweichen. Dadurch verändert sich die Bragg-Bedingung. Diese Veränderung wird im Auswerteverfahren berücksichtigt. Das Auswerteverfahren wird im Folgenden beschrieben:

Alle geometrischen Größen, die sich auf das geschriebene Hologramm beziehen und nicht auf das Interferenzmuster werden als gestrichene Größen dargestellt.

Für die Braggkurve $\eta(\Omega)$ eines Reflexionshologramms gilt nach Kogelnik:

$$\eta = \begin{cases} \dfrac{1}{1 - \dfrac{1-(\xi/\nu)^2}{\sin^2\left(\sqrt{\xi^2 - \nu^2}\right)}}, \text{für } \nu^2 - \xi^2 < 0 \\ \dfrac{1}{1 + \dfrac{1-(\xi/\nu)^2}{\sinh^2\left(\sqrt{\nu^2 - \xi^2}\right)}}, \text{für } \nu^2 - \xi^2 \geq 0 \end{cases}$$

mit:

$$\nu = \frac{\pi \cdot \Delta n \cdot d'}{\lambda \cdot \sqrt{|c_s \cdot c_r|}}$$

$$\xi = -\frac{d'}{2 \cdot c_s} \cdot DP$$

$$c_s = \cos(\vartheta') - \cos(\psi') \cdot \frac{\lambda}{n \cdot \Lambda'}$$

$$c_r = \cos(\vartheta')$$

$$DP = \frac{\pi}{\Lambda'} \cdot \left(2 \cdot \cos(\psi' - \vartheta') - \frac{\lambda}{n \cdot \Lambda'}\right)$$

$$\psi' = \frac{\beta' + \alpha'}{2}$$

$$\Lambda' = \frac{\lambda}{2 \cdot n \cdot \cos(\psi' - \alpha')}$$

Beim Auslesen des Hologramms ("reconstruction") gilt wie analog oben dargestellt:

$$\vartheta'_0 = \theta_0 + \Omega$$

$$\sin(\vartheta'_0) = n \cdot \sin(\vartheta')$$

An der Bragg-Bedingung ist das "Dephasing" DP = 0. Und es folgt entsprechend:

$$\alpha'_0 = \theta_0 + \Omega_{reconstruction}$$
$$\sin(\alpha'_0) = n \cdot \sin(\alpha')$$

Der noch unbekannt Winkel β' kann aus dem Vergleich der Bragg-Bedingung des Interferenzfeldes beim Schreiben des Hologramms und der Bragg-Bedingung beim Auslesen des Hologramms ermittelt werden unter der Annahme, dass nur Dickenschwindung stattfindet. Dann folgt:

$$\sin(\beta') = \frac{1}{n} \cdot \left[\sin(\alpha_0) + \sin(\beta_0) - \sin(\theta_0 + \Omega_{reconstruction})\right]$$

ν ist die Gitterstärke, ξ ist der Detuning Parameter und ψ' die Orientierung (Slant) des Brechungsindexgitters das geschrieben wurde. α' und β' entsprechen den Winkeln $\alpha_0$ und $\beta_0$ des Interferenzfeldes beim Schreiben des Hologramms, aber im Medium gemessen und für das Gitter des Hologramms gültig (nach Dickenschwindung). n ist der mittlere Brechungsindex des Photopolymers und wurde zu 1.504 gesetzl. λ ist die Wellenlänge des Laserlichts im Vakuum.

Die maximale Beugungseffizienz (DE = $\eta_{max}$) ergibt sich dann für ξ = 0 zu:

$$DE = \tanh^2(\nu) = \tanh^2\left(\frac{\pi \cdot \Delta n \cdot d'}{\lambda \cdot \sqrt{\cos(\alpha') \cdot \cos(\alpha' - 2\psi)}}\right)$$

Die Messdaten der Beugungseffizienz, die theoretische Braggkurve und die transmittierte Intensität werden wie in Figur 2 gezeigt gegen den zentrierten Drehwinkel $\Delta\Omega \equiv \Omega_{reconstruction} - \Omega = \alpha'_0 - \vartheta'_0$, auch Winkeldetuning genannt, aufgetragen.

Da DE bekannt ist wird die Form der theoretischen Braggkurve nach Kogelnik nur noch durch die Dicke *d'* der Photopolymerschicht bestimmt. Δn wird über DE für gegebene Dicke *d'* so nachkorrigiert, dass Messung und Theorie von DE immer übereinstimmen. *d'* wird nun solange angepasst bis die volle Breite bei halber Höhe (FWHM) für die theoretische Braggkurve und für die transmittierte Intensität übereinstimmen.

Da die Richtung in der ein Reflexionshologramm bei der Rekonstruktion mittels eines Ω-Scans mitrotiert, der Detektor für das abgebeugte Licht aber nur einen endlichen Winkelbereich erfassen kann, wird die Braggkurve von breiten Holgrammen (kleines *d'*) bei einem Ω-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke *d'* zusätzlich herangezogen.

Figur 2 zeigt die gemessene transmittierte Leistung $P_T$ (rechte γ-Achse) als durchgezogene Linie gegen das Winkeldetuning ΔΩ aufgetragen, die gemessene Beugungseffizienz η (linke γ-Achse) als ausgefüllte Kreise gegen das Winkeldetuning ΔΩ aufgetragen (soweit die endliche Größe des Detektors es erlaubte) und die Anpassung der Kogelnik Theorie als gestrichelte Linie (linke γ-Achse).

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis *E* ergibt sich wie folgt aus den Leistungen der zwei den Winkeln $\alpha_0$ und $\beta_0$ zugeordneten Teilstrahlen (Referenzstrahl mit $P_r$ = 1.55 mW und Signalstrahl mit $P_s$ = 1.96 mW), der Belichtungszeit t und dem Durchmesser der Irisblende (0.4 cm):

$$E\ (\mathrm{mJ/cm^2}) = \frac{2 \cdot [P_r + P_s] \cdot t\ (\mathrm{s})}{\pi \cdot 0.4^2\ \mathrm{cm}^2}$$

Die Leistungen der Teilstrahlen wurden so angepasst, dass in dem Medium bei den verwendeten Winkeln $\alpha_0$ und $\beta_0$, die gleiche Leistungsdichte erreicht wird.

In Beispielen wird jeweils der maximale Wert in Δn berichtet.

## Herstellung der Komponenten und Medien

### Herstellung von Polyol 1:

In einen mit Rührwerk ausgestatteten 20 1 - Reaktionskessel wurden 2,48 kg eines difunktionellen Polytetrahydrofuranpolyetherpolyols (Equivalentgewicht 325 g/Mol OH) eingewogen und 452,6 mg DMC-Katalysator zugegeben. Dann wurde unter Rühren bei ca. 70 U/min. auf 105 °C erhitzt. Durch dreimaliges Anlegen von Vakuum und Entspannen mit Stickstoff wurde Luft gegen Stickstoff ausgetauscht. Nach Erhöhung der Rührerdrehzahl auf 300 U/min.wurde für 57 Minuten bei laufender Vakuumpumpe und einem Druck von etwa 0,1 bar von unten Stickstoff durch die Mischung geleitet. Danach wurden mittels Stickstoff ein Druck von 0,5 bar eingestellt und 100 g Ethylenoxid (EO) und 150 g PO parallel zum Start der Polymerisation eingeleitet. Hierbei stieg der Druck auf 2,07 bar. Nach 10 Minuten war der Druck wieder auf 0,68 bar abgefallen und es wurden über einen Zeitraum von 1h 53 min. weitere 5,12 kg EO und 7,56 kg PO als Gemisch bei 2,34 bar zugeleitet. 31 Minuten nach Ende der Epoxiddosierung wurde bei einem Restdruck von 2,16 bar Vakuum angelegt und vollständig entgast. Der Produkt wurde durch Zugabe von 7,5 g Irganox 1076 stabilisiert und als, leicht trübe, viskose Flüssigkeit erhalten (OH-Zahl 27,1 mg KOH/g, Viskosität bei 25 °C: 1636 mPas).

### Herstellung des Acrylates 1 (Phosphorthioyltris(oxy-4,1-phenyleniminocarbonyloxyethan-2,1-diyl)-triacrylat):

In einem 500 mL Rundkolben wurden 0.1 g 2,6-Di-tert.-butyl-4-methylphenol, 0.05 g Dibutylzinn-dilaurat (Desmorapid® Z, Bayer MaterialScience AG, Leverkusen, Deutschland) sowie und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

### Herstellung des Acrylates 2 2-({[3-(Methylsulfanyl)phenyl]carbamoyl}oxy)ethylprop-2-enoat):

In einem 100 mL Rundkolben wurden 0.02 g 2,6-Di-tert.-butyl-4-methylphenol, 0.01 g Desmorapid® Z, 11.7 g 3-(Methylthio)phenylisocyanat vorgelegt und auf 60 °C erwärmt. Anschließend wurden 8.2 g 2-Hydroxyethylacrylat zugetropft und die Mischung weiter auf
60 °C gehalten, bis der Isocyanatgehalt unter 0.1 % gesunken war. Danach wurde abgekühlt. Das Produkt wurde als hellgelbe Flüssigkeit erhalten.

### Herstellung des Additives 1: (Bis(2,2,3,3,4,4,5,5,6,6,7,7-dodecafluorheptyl)-(2,2,4-trimethylhexan-1,6-diyl)biscarbamat):

In einem Rundkolben wurden 0,02 g Desmorapid Z und 3,6 g 2,4,4-Trimethylhexane-1,6-diisocyanat vorgelegt und auf 70 °C erwärmt. Anschließend wurden 11,39 g 2,2,3,3,4,4,5,5,6,6,7,7-Dodecafluorheptan-1-ol zugetropft und die Mischung weiter auf 70 °C gehalten, bis der Isocyanatgehalt unter 0.1 % gesunken war. Danach wurde abgekühlt. Das Produkt wurde als farbloses Öl erhalten.

## Beispiel Medium 1

2,00 g Acrylat 1, 2,00 g Acrylat 2, 1,50 g Additiv 1 wurden in 2,907 g Polyol 1 bei 60 °C gelöst. Dann wurden 0,18 g Coinitiator 2 und 0,015 g Glasperlen mit Durchmesser 10 μm zugegeben. Im Dunkeln wurde eine Lösung von 0,03 g Coinitiator 1 und 0.015 g Farbstoff 1 in 1,492 g N-Ethylpyrilidon gemischt, so dass eine klare Lösung erhalten wurde. Die oben beschriebene Polyollösung wurde im Dunkeln mit der zuletzt beschriebenen Lösung bei ca. 35°C gemischt. Anschließend wurde auf 30 °C abgekühlt, 0,367 g Isocyanatkomponente 1 und 0,006 g Katalysator 1 zugegeben und erneut gemischt. Die erhaltene, flüssige Masse wurde dann auf eine Glasplatte gegeben und dort mit einer zweiten Glasplatte abgedeckt, die durch die Glasperlen auf einen Abstand von 10 μm gehalten wurde. Dieser Probenkörper wurde bei Raumtemperatur liegen gelassen und über 16 Stunden gehärtet.

## Beispiel Medium 2

2,00 g Acrylat 1, 2,00 g Acrylat 2, 1,50 g Additiv 1 wurden in 2,907 g Polyol 1 bei 60 °C gelöst. Dann wurden 0,02 g Coinitiator 2 und 0,015 g Glasperlen mit Durchmesser 10 μm zugegeben. Im Dunkeln wurde eine Lösung von 0,27 g Coinitiator 1 und 0.015 g Farbstoff 1 in 1,492 g N-Ethylpyrilidon gemischt, so dass eine klare Lösung erhalten wurde. Die oben beschriebene Polyollösung wurde im Dunkeln mit der zuletzt beschriebenen Lösung bei ca. 35°C

gemischt. Anschließend wurde auf 30 °C abgekühlt, 0,367 g Isocyanatkomponente 1 und 0,006 g Katalysator 1 zugegeben und erneut gemischt. Die erhaltene, flüssige Masse wurde dann auf eine Glasplatte gegeben und dort mit einer zweiten Glasplatte abgedeckt, die durch die Glasperlen auf einen Abstand von 10 μm gehalten wurde. Dieser Probenkörper wurde bei Raumtemperatur liegen gelassen und über 16 Stunden gehärtet.

**Beispiel Medium 3**

2,00 g Acrylat 1, 2,00 g Acrylat 2, 1,50 g Additiv 1 wurden in 2,907 g Polyol 1 bei 60 °C gelöst. Dann wurden 0,10 g Coinitiator 2 und 0,015 g Glasperlen mit Durchmesser 10 μm zugegeben. Im Dunkeln wurde eine Lösung von 0,15 g Coinitiator 1 und 0.015 g Farbstoff 2 in 1,492 g N-Ethylpyrilidon gemischt, so dass eine klare Lösung erhalten wurde. Die oben beschriebene Polyollösung wurde im Dunkeln mit der zuletzt beschriebenen Lösung bei ca. 35°C gemischt. Anschließend wurde auf 30 °C abgekühlt, 0,367 g Isocyanatkomponente 1 und 0,006 g Katalysator 1 zugegeben und erneut gemischt. Die erhaltene, flüssige Masse wurde dann auf eine Glasplatte gegeben und dort mit einer zweiten Glasplatte abgedeckt, die durch die Glasperlen auf einen Abstand von 10 μm gehalten wurde. Dieser Probenkörper wurde bei Raumtemperatur liegen gelassen und über 16 Stunden gehärtet.

Anmerkung: Da unterschiedliche Formulierungen mit unterschiedlicher Ausgangsviskosität und unterschiedlicher Härtungsgeschwindigkeit der Matrix zu nicht immer gleichen Schichtdicken d der Photopolymerschicht führen, wird d anhand der Charakteristika der geschriebenen Hologramme für jede Probe separat ermittelt.

Tabelle 1: Übersicht der Beispiel-Medien 1-3

| Beispiel | Δn | Gesamtdosis E [mJ/cm$^2$] |
|---|---|---|
| Medium 1 | 0,0352 | 100 ~ 850 |
| Medium 2 | 0,0200 | 200 ~ 1750 |
| Medium 3 | 0,0240 | 800 ~ 1750 |

Die gefundenen Werte für den dynamischen Bereich zeigen, dass die in den Beispiel-Medien 1 bis 3 verwendeten Photopolymer-Formulierungen für die Herstellung holographischer Medien aufgrund des hohen Wertes für Δn für visuelle Hologramme sehr gut geeignet sind.

**Patentansprüche**

1. Photopolymer-Formulierung umfassend chemisch vernetzte Matrixpolymere, Schreibmonomere und ein Photoinitiatorsystem, **dadurch gekennzeichnet, dass** das Photoinitiatorsystem ein HABI, einen auf das HABI abgestimmten Farbstoff mit einem Absorptionsmaximum im Bereich von 400-800 nm und einen Wasserstoff-Donor enthält.

2. Photopolymer-Formulierung nach Anspruch 1, **dadurch gekennzeichnet, dass** das HABI eine Verbindungen der Formel (I) ist

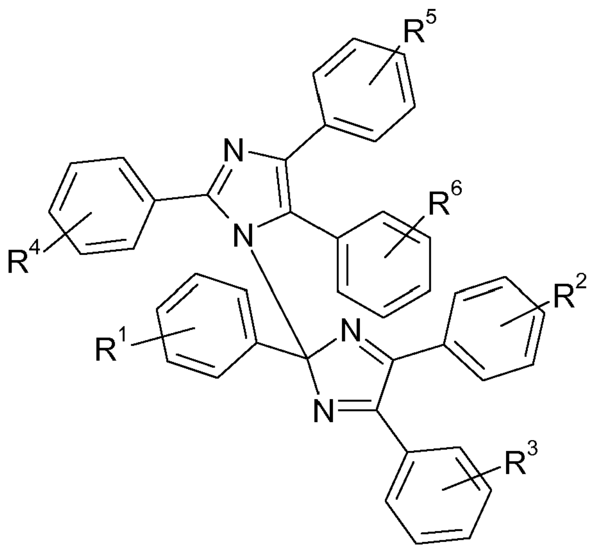

(I)

in der

$R^1$, $R^4$ jeweils unabhängig voneinander ein Chlor-, ein Methoxy- und / oder ein Ethoxy-Rest und
$R^2$, $R^3$, $R^5$, $R^6$ jeweils unabhängig voneinander ein oder mehrere Wasserstoff-, Chlor-, Methoxy-, und / oder Ethoxy-Reste sind.

3. Photopolymer-Formulierung nach Anspruch 2 **dadurch gekennzeichnet, dass** $R^1$ und $R^4$ jeweils ein Chlor-Rest- oder Methoxy- oder Ethoxy-Reste sind.

4. Photopolymer-Formulierung nach einem der Ansprüche 2 der 3 **dadurch gekennzeichnet, dass** $R^2$, $R^3$, $R^5$, $R^6$ jeweils ein Wasserstoff-Rest sind.

5. Photopolymer-Formulierung nach einem der Ansprüche 1 bis 4, **dadurch gekennzeichnet, dass** der Wasserstoff-Donor ausgewählt aus der Gruppe Alkylamin, Alkylaminoalkohol, substituierter Glycin-Ester, aromatisches oder aliphatisches Thiol, aromatisches oder aliphatisches Amin, aromatisches oder benzylisches Disulfid, aromatisches oder benzylisches Diselenid ist.

6. Photopolymer-Formulierung nach einem der Ansprüche 1 bis 4 **dadurch gekennzeichnet, dass** der Wasserstoff-Donor 2-Mercapto-1-methylimidazol, 1-Phenyl-1H-tetrazole-5-thiol, Mercaptobenzothiazol, Phenyldisulfid, Dodecanethiol, 2(3H)-Benzoxazolethion, 1H-1,2,4-Triazole-3-thiol, 5,5'-Dithiobis-1-phenyl-1H-tetrazol, 1-Methyl-1H-tetrazole-5-thiol, 5-Methyl-1,3,4-thiadiazole-2-thiol, N-Phenylglycinethylester, N-Phenylglycinmethylester ist.

7. Photopolymer-Formulierung nach einem der Ansprüche 1 bis 6, **dadurch gekennzeichnet, dass** die chemisch vernetzten Matrixpolymere Polyurethane sind.

8. Photopolymer-Formulierung nach einem der Ansprüche 1 bis 7, **dadurch gekennzeichnet, dass** die Schreibmonomere ein mono- und / oder ein multifunktionales Schreibmonomer umfassen, wobei es sich insbesondere um ein mono- und / oder ein multifunktionelles Acrylat handeln kann.

9. Photopolymer-Formulierung nach Anspruch 8, **dadurch gekennzeichnet, dass** das Acrylat die allgemeine Formel (III)

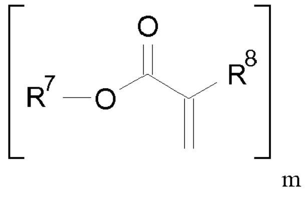

(III)

hat, in der m≥1 und m≤4 ist und $R^7$, $R^8$ unabhängig voneinander Wasserstoff, lineare, verzweigte, cyclische oder heterocyclische unsubstituierte oder gegebenenfalls auch mit Heteroatomen substituierte organische Reste sind.

**10.** Photopolymer-Formulierung nach einem der Ansprüche 1 bis 9, **dadurch gekennzeichnet, dass** sie zusätzlich Urethane als Weichmacher enthält, wobei die Urethane insbesondere mit wenigstens einem Fluoratom substituiert sein können.

**11.** Photopolymer-Formulierung nach Anspruch 10, **dadurch gekennzeichnet, dass** die Urethane die allgemeine Formel (IV)

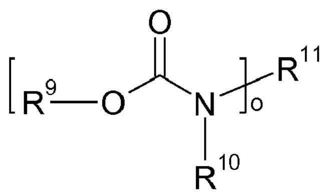

(IV)

haben, in der o≥1 und o≤8 ist und $R^9$, $R^{10}$, $R^{11}$ unabhängig voneinander Wasserstoff lineare, verzweigte, cyclische oder heterocyclische unsubstituierte oder gegebenenfalls auch mit Heteroatomen substituierte organische Reste sind, wobei bevorzugt mindestens einer der Reste $R^9$, $R^{10}$, $R^{11}$ mit wenigstens einem Fluoratom substituiert ist und besonders bevorzugt $R^9$ ein organischer Rest mit mindestens einem Fluoratom ist.

**12.** Verwendung einer Photopolymer-Formulierung nach einem der Ansprüche 1 bis 11 zur Herstellung holographischer Medien, insbesondere zur Herstellung von In-Line Hologrammen, Off-Axis Hologrammen, Full-Aperture Transfer Hologrammen, Weißlicht-Transmissionshologrammen, Denisyukhologrammen, Off-Axis Reflektionshologrammen, Edge-Lit Hologrammen sowie holographischen Stereogrammen.

**13.** Verfahren zur Herstellung von belichteten holographischen Medien, bei dem ein holographisches Medium aus einer Photopolymer-Formulierung gemäß einem der Ansprüche 1 bis 11 hergestellt und in das Medium mit elektromagnetischer Strahlung ein Hologramm einbelichtet wird.

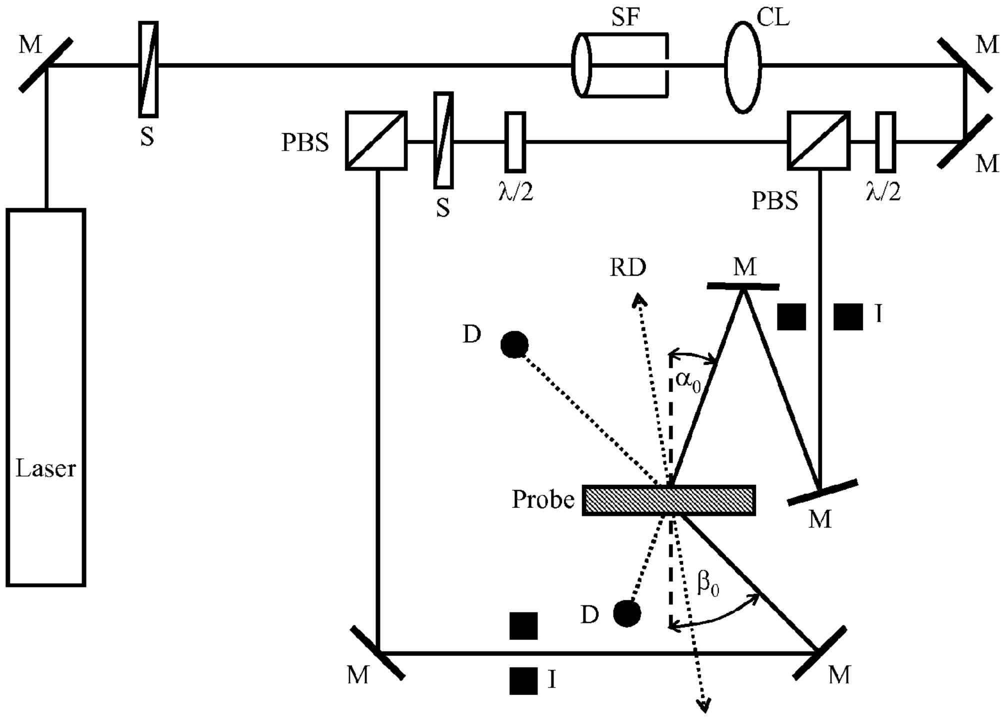
SF
CL
M
S
PBS
S
λ/2
PBS
λ/2
M
M
RD
M
D
I
α0
Laser
Probe
M
β0
D
M
I
M

Fig. 1

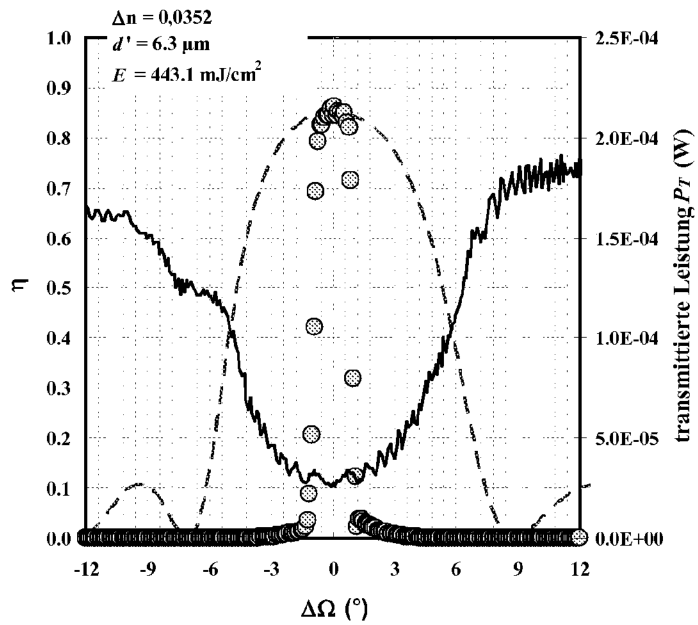
Δn = 0,0352
d' = 6.3 µm
E = 443.1 mJ/cm2
η
transmittierte Leistung PT (W)
ΔΩ (°)
1.0
0.9
0.8
0.7
0.6
0.5
0.4
0.3
0.2
0.1
0.0
2.5E-04
2.0E-04
1.5E-04
1.0E-04
5.0E-05
0.0E+00
-12
-9
-6
-3
0
3
6
9
12

Fig. 2

Europäisches Patentamt
European Patent Office
Office européen des brevets

# EUROPÄISCHER RECHERCHENBERICHT

Nummer der Anmeldung
EP 10 15 8100

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br><br><br>Y | EP 1 696 266 A2 (FUJI PHOTO FILM CO LTD [JP] FUJIFILM CORP [JP])<br>30. August 2006 (2006-08-30)<br>* Absatz [0274] - Absatz [0276]; Beispiel 204 *<br>* Seiten 20,35, Absätze 73,78; Verbindungen S-93,I-2 *<br>* Absatz [0199] *<br>* Absatz [0205] - Absatz [0233] *<br>* Absatz [0203] *<br>* Seite 61; Beispiel 404 *<br>----- | 1-9,12, 13<br><br><br>10,11 | INV.<br>G03F7/00<br>G03H1/02<br>G03F7/031 |
| X<br><br>Y | US 2007/077498 A1 (YUMOTO MASATOSHI [JP] ET AL) 5. April 2007 (2007-04-05)<br>* Absätze [0212] - [0219]; Beispiel 1 *<br>* Absatz [0047]; Anspruch 4 *<br>* Absatz [0072]; Ansprüche 10,11,16,17 *<br>----- | 1,5,7-9, 12,13<br><br>6 | |
| X<br><br><br>Y | WO 03/077033 A2 (CHEBEN PAVEL [CA]; CALVO MARIA LUISA [ES])<br>18. September 2003 (2003-09-18)<br>* Seite 11, Zeile 12 - Zeile 17; Abbildung 1; Beispiel 4; Tabelle 1 *<br>* Seite 8, Zeile 10 - Seite 9, Zeile 2 *<br>* Seite 6, Zeile 10 - Zeile 13 *<br>----- | 1,5,8,9, 12,13<br><br><br>6 | RECHERCHIERTE SACHGEBIETE (IPC)<br>G03F<br>G03H |
| Y | EP 1 460 478 A1 (ETERNAL TECHNOLOGY CORP [US]) 22. September 2004 (2004-09-22)<br>* Absatz [0067] - Absatz [0068] *<br>----- | 10,11 | |
| A | JP 2005 181955 A (KONICA MINOLTA MED & GRAPHIC) 7. Juli 2005 (2005-07-07)<br>* Beispiele 19,20; Tabelle 1 *<br>* Absatz [0096]; Verbindungen E-7,E-11 *<br>----- | 1-13 | |
| A | JP 2008 164730 A (MITSUBISHI CHEM CORP)<br>17. Juli 2008 (2008-07-17)<br>* das ganze Dokument *<br>-----<br>-/-- | 1-13 | |

Der vorliegende Recherchenbericht wurde für alle Patentansprüche erstellt

1

| Recherchenort | Abschlußdatum der Recherche | Prüfer |
|---|---|---|
| München | 16. Juli 2010 | Beckert, Audrey |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Europäisches Patentamt
European Patent Office
Office européen des brevets

# EUROPÄISCHER RECHERCHENBERICHT

Nummer der Anmeldung
EP 10 15 8100

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 3 533 797 A (JAMES DANIEL S ET AL) 13. Oktober 1970 (1970-10-13)<br>* das ganze Dokument *<br>----- | 1-13 | |
| | | | RECHERCHIERTE SACHGEBIETE (IPC) |

Der vorliegende Recherchenbericht wurde für alle Patentansprüche erstellt

1

| Recherchenort | Abschlußdatum der Recherche | Prüfer |
|---|---|---|
| München | 16. Juli 2010 | Beckert, Audrey |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 10 15 8100

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-07-2010

| Im Recherchenbericht angeführtes Patentdokument | Datum der Veröffentlichung | Mitglied(er) der Patentfamilie | Datum der Veröffentlichung |
|---|---|---|---|
| EP 1696266 A2 | 30-08-2006 | JP 2006235386 A<br>US 2006194122 A1 | 07-09-2006<br>31-08-2006 |
| US 2007077498 A1 | 05-04-2007 | KEINE | |
| WO 03077033 A2 | 18-09-2003 | AU 2003212139 A1 | 22-09-2003 |
| EP 1460478 A1 | 22-09-2004 | CN 1601380 A<br>KR 20040084654 A<br>KR 20070049625 A<br>TW 242107 B | 30-03-2005<br>06-10-2004<br>11-05-2007<br>21-10-2005 |
| JP 2005181955 A | 07-07-2005 | JP 4466140 B2 | 26-05-2010 |
| JP 2008164730 A | 17-07-2008 | KEINE | |
| US 3533797 A | 13-10-1970 | NL 6800995 A | 25-03-1968 |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008125229 A1
- US 3652275 A
- US 4917977 A
- US 4963471 A
- US 5470813 A
- EP A A
- EP 700949 A
- EP 743093 A
- EP 761708 A
- WO 9740086 A
- WO 9816310 A
- WO 0047649 A


### In der Beschreibung aufgeführte Nicht-Patentliteratur


- **P. HARIHARAN.** Optical Holography. Cambridge University Press, 1996
- **WILLIE W. ; HONG, CHI-SHAIN ; YARIV, AMNON.** Holographic interference lithography for integrated optics. *IEEE Transactions on Electron Devices,* 1978, vol. ED-25 (10), ISSN 0018-9383, 1193-1200
- **H. KOGELNIK.** *The Bell System Technical Journal,* November 1969, vol. 48 (9), 2909, 2947